(19) Europäisches Patentamt
European Patent Office
Office européen des brevets

(11) **EP 1 297 542 B1**

(12) **EUROPÄISCHE PATENTSCHRIFT**

(45) Veröffentlichungstag und Bekanntmachung des Hinweises auf die Patenterteilung:
**20.02.2013 Patentblatt 2013/08**

(21) Anmeldenummer: **01942944.8**

(22) Anmeldetag: **03.07.2001**

(51) Int Cl.:
*H01F 13/00* (2006.01)  *H01F 41/14* (2006.01)
*H01F 41/18* (2006.01)  *H01J 37/34* (2006.01)
*C23C 14/35* (2006.01)

(86) Internationale Anmeldenummer:
**PCT/CH2001/000411**

(87) Internationale Veröffentlichungsnummer:
**WO 2002/003402 (10.01.2002 Gazette 2002/02)**

(54) **ANORDNUNG ZUR AUSRICHTUNG DER MAGNETISIERUNGSRICHTUNG MAGNETISCHER SCHICHTEN**

DEVICE FOR ORIENTING THE DIRECTION OF MAGNETIZATION OF MAGNETIC LAYERS

DISPOSITIF DESTINE A ORIENTER LE SENS DE MAGNETISATION DE COUCHES MAGNETIQUES

(84) Benannte Vertragsstaaten:
**AT BE CH CY DE DK ES FI FR GB GR IE IT LI LU MC NL PT SE TR**

(30) Priorität: **06.07.2000 CH 133800**

(43) Veröffentlichungstag der Anmeldung:
**02.04.2003 Patentblatt 2003/14**

(73) Patentinhaber: **OC Oerlikon Balzers AG
9496 Balzers (LI)**

(72) Erfinder: **MAASS, Wolfram
63589 Linsengericht/Grossenhausen (DE)**

(74) Vertreter: **Troesch Scheidegger Werner AG
Schwäntenmos 14
8126 Zumikon (CH)**

(56) Entgegenhaltungen:
**EP-A- 0 406 667    US-A- 4 600 488
US-A- 5 630 916**

**Beschreibung**

Die vorliegende Erfindung betrifft eine Anordnung zur Ausrichtung der Magnetisierungsrichtung dünner Schichten auf scheibenförmigen Substraten mit einer Substrathalterung für mindestens ein Substrat, die eine Positionierungsebene für das mindestens eine Substrat definiert, und bei der, auf einer Seite der Positionierungsebene, eine Magnetanordnung vorgesehen ist. Dies nach dem Oberbegriff von Anspruch 1.

Die Erfindung betrifft weiter eine Vakuumbeschichtungsanlage nach dem Oberbegriff von Anspruch 18, ein Substrat mit mindestens einer magnetischen Schicht nach demjenigen von Anspruch 22, ein Verfahren zur Herstellung von Substraten nach dem Oberbegriff von Anspruch 20 sowie eine Verwendung der Anordnung nach Anspruch 24.

Bei der Herstellung magnetischer Schichten, z.B. durch Kathodenzerstäuben, ist es oft erwünscht, in diesen Schichten eine magnetische Anisotropie zu erzeugen, welche eine SOLL-Verteilung innerhalb und entlang der Schicht aufweist. Als SOLL-Verteilung wird insbesondere oft eine einachsige, d.h. kolineare magnetische Anisotropie verlangt, deren Richtung in bezug auf das Substrat festgelegt ist.

Unter einer kolinearen Anisotropie bzw. kolinearen Anisotropie-Verteilung sei verstanden eine magnetische Anisotropie, die entlang eines betrachteten Schichtbereiches gleichgerichtet ist. In diesem Sinne kann auch von einer "Homogenität der Anisotropie" gesprochen werden.

Dabei sind normalerweise nur kleine Winkelabweichungen der Anisotropierichtung von der vorgegebenen Richtung erlaubt. Eine derartige Anisotropie in der magnetischen Schicht wird dadurch erreicht, dass während der Substratbeschichtung ein entsprechend gerichtetes bzw. ausgerichtetes magnetisches Feld im Beschichtungsbereich zur Wirkung gebracht wird. Die magnetische Anisotropie hat dann, nach der Beschichtung, die Richtung des vormals angelegten Feldes.

Aus der DE-OS 196 43 841 ist es bekannt, an einem Substratträger, radial versetzt um das Zentrum verteilt, Substrate anzuordnen und sie dort mit einem magnetischen Werkstoff zu beschichten. Der Substratträger wird dabei um die Zentralachse rotiert. Unterhalb der durch die Substrathalterungen am Träger festgelegten Positionierungsebene für die Substrate ist, bezüglich der Zentralachse radial ausgerichtet, ein stationärer Elektromagnet mit Spule und Joch vorgesehen, welch letzteres unmittelbar unter der Positionierungsebene ein im wesentlichen radial zur Zentralachse gerichtetes Magnetfeld erzeugt. Dieses Vorgehen ist unter verschiedenen Aspekten nachteilig:

• Sollen grössere Substrate beschichtet werden, so wird aufgrund der zwingend exzentrischen Lagerung und Substratträger-Rotation die Trägeranordnung ausserordentlich gross und mechanisch aufwendig. Die Trägergrösse wirkt sich dabei nachteilig aus auf die Beschichtungsrate, beispielsweise mittels Sputterquellen.

• Die Herstellung von Substraten mit Mehrlagen-Schichtsystemen aus eventuell verschiedenen magnetischen Materialien verbunden mit der Forderung, in den verschiedenen magnetischen Schichten unterschiedliche Anisotropie-Verteilungen, insbesondere -Richtungen, zu realisieren, kann mit dieser vorbekannten Anordnung mit ausschliesslich radial gerichteten Magnetfeldern nicht realisiert werden, es sei denn, man positioniere die Substrate jeweils um, um unterschiedliche Anisotropierichtungen an unterschiedlichen Substratschichten zu realisieren.

Aus der US-A-5 630 916 ist es bekannt, unterhalb einer Positionierungsebene für Substrate einen Elektromagneten vorzusehen, der sich weit über die Ausdehnung des Substrates erstreckt. Um kolineare Feldlinien im Substratbereich zu erzeugen, muss dabei die Dimension des Elektromagneten deutlich grösser sein als die Substratdimension. Es besteht auch hier keine Möglichkeit, bei Mehrlagenschichten auf dem Substrat den magnetischen Einzelschichten unterschiedliche Anisotropie-Verteilungen, insbesondere -Richtungen, aufzuprägen, ohne dafür das Substrat zwischen den einzelnen Beschichtungsschritten geometrisch zu drehen. Ein weiterer Nachteil besteht darin, wie bei allen Anordnungen zur Magnetfelderzeugung im Substratbereich, bei denen eine geschlossene Jochplatte eventuell mit Spule unterhalb der Substratebene vorhanden ist, dass es schwierig oder unmöglich ist, mechanische Vorrichtungen z.B. zur Substratbewegung von unten an das Substrat heranzubringen. Solche Vorrichtungen sind aber in modernen Beschichtungsanlagen oft erforderlich, z.B. zum Substrattransport. Gleiche Probleme ergeben sich, wenn das Substrat von unten gekühlt oder geheizt werden soll oder auch zum Anbringen von Messeinrichtungen.

Aus der DE-OS 43 12 444 ist ein Vorgehen, ähnlich dem im Zusammenhang mit der DE-OS 196 43 841 beschriebenen, vorbekannt, bei welchem die Distanz zwischen einem radial angeordneten Permantentmagneten und dem exzentrisch drehgelagerten Substrat eingestellt werden kann.

Aus der EP-A-0 435 838 ist es bekannt, koaxial zu einem Substratträger eine polygonal gewickelte, ebene Spule vorzusehen, womit auf dem zentrisch gelagerten Substrat eine radiale, magnetische Anisotropie erzielt wird. Die bereits oben aufgeführten Nachteile treffen im wesentlichen auch auf diese Anordnung zu.

Aus der EP-A-0 584 768 ist es weiter bekannt, eine uniaxiale Anisotropie mit kleinen Winkelabweichungen an magnetisch beschichteten, rechteckigen Substraten dadurch zu erzeugen, dass parallele Stabmagnete lateral unterhalb des Substrates angeordnet werden. Auch hier ist ein Wechsel zwischen SOLL-Anisotropie-Verteilungen nicht möglich, es sei denn, wie bei den vorerwähnten, bekannten Vorgehen, durch mechanisches Drehen von Magnetanordnung bezüglich Substrat, was nur mit erheblichem Aufwand realisierbar ist.

Aus der US-A-4 600 488 ist es weiter bekannt, zwei Spulenpaare zur Erzeugung eines Magnetfeldes seitlich um ein Substrat herum anzuordnen, wobei jedes Spulenpaar eine gemeinsame Spulenachse besitzt, und die Spulenachsen der beiden Spulenpaare senkrecht zueinander in der Positionierungsebene des Substrates liegen. Die Spulenöffnungen erstrecken sich dabei über die Ausdehnung des Substrates hinaus. Bei dieser Lösung wird also versucht durch den Einsatz von grossen Spulen, deren Durchmesser deutlich grösser ist als die Dimension des Substrates, kolineare Magnetfeldlinien möglichst über den gesamten Bereich des Substrates zu erzeugen. Die Ausrichtung des Magnetfeldes kann dabei durch entsprechende Wahl der Spulenströme eingestellt werden.

Es ist Aufgabe der vorliegenden Erfindung, eine Anordnung bzw. eine Beschichtungsanlage bzw. ein Herstellungsverfahren vorzuschlagen, mittels welchen

- auf einfache Art und Weise eine erwünschte SOLL-Anisotropie-Verteilung an mindestens einer magnetischen Schicht eines Substrates realisierbar ist. Dabei soll insbesondere für die Vakuumbeschichtung eines Substrates mit einer weichmagnetischen Schicht, die erwünschte SOLL-Anisotropieverteilung eine in vorgegebener Richtung kolineare Anisotropie sein;

- ohne mechanische Veränderung der Relativposition von Substrat und Magnetanordnung mehrere auf einem Substrat vorgesehene weichmagnetische Schichten mit unterschiedlichen Anisotropie-Verteilungen, insbesondere -Richtungen, realisiert werden können, indem die zu erzielende Anisotropie-Verteilung bzw. -Richtung einfach eingestellt werden kann;

- grossflächige Substrate mit erwünschter magnetischer Anisotropie-Verteilung beaufschlagt werden können, insbesondere mit einer kolinearen in vorgegebener bzw. vorgebbarer Richtung. Ganz besonders bei grossflächigen Substraten mit den genannten Schichten soll eine sehr gute Kolinearität der Anisotropierichtung, mindestens weitestgehend im gesamten Substratbereich, erreicht werden können.

Diese Aufgabe wird an der erfindungsgemässen Anordnung dadurch gelöst, dass, dem Wortlaut des kennzeichnenden Teils von Anspruch 1 folgend, die Magnetanordnung mindestens drei Elektromagnete umfasst, deren Dipol-Achsen mindestens genähert parallel zur Positionierungsebene liegen und, senkrecht zur Positionierungsebene betrachtet, eine geschlossene Fläche aufspannen. Dadurch wird es möglich, durch Überlagerung der Felder der Elektromagnete und entsprechender Bemessung und Ausrichtung ihrer Dipole, in der Positionierungsebene bzw. in der entsprechenden magnetischen Schicht eines auf der Substrathalterung gehaltenen Substrates ein erwünschtes resultierendes Feldlinienmuster zu realisieren bzw. eine SOLL-Anisotropie-Richtungsverteilung, und diese z.B. für die Beaufschlagung einer zweiten Schicht höchst einfach umzuschalten, wie noch erläutert werden wird.

In einer bevorzugten Ausführungsform der erfindungsgemässen Anordnung liegen die Dipolachsen in einer Ebene parallel zur Positionierungsebene. Weiter spannen sie, bevorzugt zusätzlich, bevorzugt ein regelmässiges n-Eck auf, wobei weiter bevorzugt mehr als drei Elektromagnete vorgesehen sind, wobei n die Anzahl der Elektromagnete ist.

Insbesondere mit Blick auf das Bedürfnis, an den erwähnten Schichten eine homogene Verteilung der Anisotropie-Richtung innerhalb möglichst grosser Bereiche der Schicht zu realisieren, diese Anisotropie aber bezüglich ihrer Richtung weiterhin höchst einfach ändern zu können, wird vorgeschlagen, dass eine gerade Anzahl Elektromagnete vorgesehen ist, vorzugsweise eine durch 4 teilbare Anzahl, womit - wie noch zu erläutern sein wird - die Elektromagnete, in Quadranten gruppiert, bezüglich ihrer Dipolrichtungen und Dipolstärken, unter Ausnützung von Symmetrien, optimal gestellt und umgestellt werden können.

In einer weiteren bevorzugten Ausführungsform umfasst die Magnetanordnung zwei Elektromagnetgruppen, woran die Elektromagneten wie folgt gerichtete Dipole erzeugen:

- Die Dipole haben - im Sinne von Vektor-Komponenten - erste Komponenten, parallel zur Positionierungsebene und in einer ersten Richtung, die an den Elektromagneten beider Gruppen gleichgerichtet sind.

- Die Dipole haben zweite Komponenten, parallel zur Positionierungsebene und senkrecht zu der ersterwähnten Richtung, die an einer Gruppe invers zu denen der zweiten Gruppte gerichtet sind, also in sich kompensierende Richtungen weisen zwischen den Gruppen.

Im weiteren sind in bevorzugter Ausführungsform die Elektromagnete durch Spulen gebildet, welche auf einen gemeinsamen, die erwähnte Fläche umschlingenden Magnetkern gewickelt sind, dabei bevorzugterweise auf einen gemeinsamen Ringkern.

Die Abstimmung der Dipolgrössen bzw. -beträge an den Elektromagneten erfolgt in einer ersten Ausführungsform durch Vorsehen von Spulen, die mindestens teilweise unterschiedliche Wicklungszahlen aufweisen.

Die Elektromagnete sind im weiteren mit Stromgeneratoren verbunden, die sie mit DC- und/oder AC- und/oder DC- mit überlagertem AC-Strom beschicken. Wird AC-Strom eingesetzt, ggf. in Überlagerung mit DC-Strom, dann bevorzugt mit einer Frequenz f, für die gilt:

$$1 \text{ Hz} \leq f \leq 100 \text{ Hz}.$$

Anstelle oder ergänzend zur Einstellung der Dipolgrösse an den vorgesehene Elektromagneten durch Vorsehen von Spulen unterschiedlicher Wicklungszahlen wird in einer zweiten Ausführung vorgeschlagen, dass mindestens ein Teil der Elektromagnete an Stromgeneratoren angeschlossen ist, die die Elektromagnete mit Strömen beschicken, für die gilt:

- Die DC-Stromwerte sind unterschiedlich und/oder
- die AC-Stromamplituden und/oder -phasen sind unterschiedlich.

Somit kann bei vorgesehenem Satz von Elektromagneten die erwünschte Anisotropie-Verteilung, insbesondere die erwünschte Anisotropie-Richtung, durch Umsteuerung der die Elektromagnetspulen beaufschlagenden Ströme erreicht werden.

Daraus folgt unmittelbar eine weitere bevorzugte Ausführungsform der erfindungsgemässen Anordnung, bei welcher die Elektromagnete an einer Stromgeneratoranordnung angeschlossen sind, woran die Verteilung von Ausgangsströmen zu den Elektromagneten in mindestens zwei unterschiedliche Verteilungszustände umschaltbar ist. Dabei ist es selbstverständlich möglich, mehr als zwei Stromverteilungs-Zustände zu definieren und die Anisotropie-Richtung praktisch in beliebiger Richtung von 0° bis 360° in der Positionierungsebene umzusteuern. Unter Verteilung der Ausgangsströme der Generatoren verstehen wir die Verteilung von DC-Werten bzw. AC-Amplitude bzw. gegenseitiger Phasenlage der Ströme, wie sie an einem vorgegebenen Satz der Elektromagnete erzeugt werden.

Wenn Spulen der Elektromagnete auf einen gemeinsamen Ringkern gewickelt sind, dabei bevorzugterweise eine gerade Spulenzahl, insbesondere bevorzugt eine durch 4 teilbare Anzahl, und wenn eine Symmetrieebene, die die Achse des Ringkernes enthält, die Spule in zwei Gruppen teilt, wobei Richtungskomponenten der Dipole der Spulen beider Gruppen in Richtung parallel zur erwähnten Symmetrieebene gleichgerichtet sind, so wird bevorzugterweise die Stärke der Dipole mindestens genähert proportional zu einer $\cos\phi$-Funktion gewählt, wobei $\phi$ der Polarlagewinkel der jeweiligen Spule bezüglich der Achse des Ringkernes ist.

Läuft man mithin entlang den Spulen einer Gruppe um den Ringkern, so sind wie erwähnt bevorzugt die Beträge der erwähnten Dipole nach der erwähnten $\cos\phi$-Funktion ausgelegt. Dadurch wird die Kreisanordnung der Spulen berücksichtigt, mit Blick auf die Erzeugung einer resultierenden kolinearen Anisotropie. Die Anisotropie-Richtung ergibt sich in Richtung der Schnittgeraden der erwähnten Symmetrieebene mit der Positionierungsebene.

Nun ist ohne weiteres ersichtlich, dass durch Umschalten der Verteilung von die Spulen durchfliessenden Strömen die Winkellage der erwähnten Symmetrieebene um die Ringkernachse schwenkbar ist in vorgegebene Winkellagen und/oder, im Bereich 0° bis 360°, vorzugsweise in Schritten, frei wählbar.

Während nämlich die Elektromagnete ortsfest sind, ebenso wie das Substrat auf der Positionierungsebene, ergibt sich durch stromgeführte Umdefinition der erwähnten Symmetrieebene eine Verstellung der resultierenden Anisotropie-Richtung in der Positionierungsebene bzw. am Substrat.

Um im weiteren rasch von einer bevorzugten SOLL-Anisotropie-Verteilung bzw. -Richtung zu einer andern wechseln zu können, insbesondere von der Erzeugung einer kolinearen Anisotropie in einer ersten Richtung hin zur Erzeugung einer kolinearen Anisotropie in einer anderen und um hiermit, beispielsweise in zwei magnetischen Schichten eines Substrates, erst eine kolineare Anisotropie in der einen, darnach, in der zweiten Schicht, in einer zweiten Richtung, z.B. um 90° gedreht, zu erzeugen, wird vorgeschlagen, dass mindestens zwei der Magnetanordnungen vorgesehen sind, welche jeweils selektiv in Betrieb genommen werden.

Dadurch ergibt sich eine weitere Möglichkeit zur Richtungsumschaltung der Anisotropie-Richtung, hinzukommend zu der oben erwähnten, gemäss welcher diese Änderung an ein und demselben Elektromagnetsatz durch Umsteuerung der dipolerzeugenden Ströme vorgenommen wird. Selbstverständlich ist es ohne weiteres möglich, ggf. sowohl zwei oder mehr der erwähnten Magnetanordnungen vorzusehen, diese alternativ oder ggf. sogar gemeinsam zu betreiben und hinzukommend die die Dipole an den Elektromagneten der erwähnten Magnetanordnungen erzeugenden Ströme selektiv einzustellen bzw. umzusteuern.

In einer bevorzugten Ausführungsform der erfindungsgemässen Anordnung mit zwei der Magnetanordnungen wird vorgeschlagen, dass bezüglich einer Achse senkrecht zur Positionierungsebene die Magnetanordnungen koaxial angeordnet sind, dabei vorzugsweise gleich sind, aber bezüglich dieser Achse gegenseitig um einen Winkel, vorzugsweise von 90°, verdreht sind. Dadurch wird, insbesondere im Falle der oben definierten Symmetrieebene an einem Ringkern, durch jede der Magnetanordnungen eine Symmetrieebene festgelegt, die unterschiedlich gerichtet sind, wie erwähnt bevorzugterweise einen 90°-Winkel einschliessen. Es ergibt sich dadurch die Möglichkeit, die resultierende Feldrichtung bzw. Anisotropie-Richtung einfach in einem Umschaltschritt um 90° umzusteuern.

Eine höchst kompakte Bauform, bei der zusätzlich bezüglich der Positionierungsebenen für beide Magnetanordnungen identische Verhältnisse herrschen, wird dadurch erreicht, dass Spulen beider Magnetanordnungen auf denselben Kern, vorzugsweise Ringkern, gewickelt sind.

An der erfindungsgemässen Anordnung ist die Substrathalterung bevorzugterweise zur Aufnahme mindestens eines scheibenförmigen, dabei bevorzugt rechteckförmigen oder, und dies besonders bevorzugt, kreisförmigen Substrates ausgebildet. Dabei kann die Substrathalterung aber durchaus für die Aufnahme mehrerer scheibenförmiger Substrate ausgebildet sein. Jedenfalls ist aber bevorzugterweise die Magnetanordnung oder sind die zwei oder mehr Magnetanordnungen symmetrisch zu einer Zentrumsachse durch die Substrathalterung angeordnet. Ist die Substrathalterung zur Aufnahme eines Substrates ausgebildet, so wird dieses bezüglich der erwähnten Zentrumsachse zentriert an der Halterung vorgesehen, werden mehrere Substrate auf der Halterung vorgesehen, so in analoger Weise um die erwähnte Achse herum zentriert gruppiert.

Weil mit der erfindungsgemässen Anordnung in der erwähnten Positionierungsebene grossflächig ein kolineares Feldlinienmuster realisierbar ist und daraus entsprechend grossflächig eine kolineare Anisotropieverteilung an der oder den magnetischen Schichten eines Substrates, kann in bevorzugter Ausführungsform die Substrathalterung für die Aufnahme mindestens eines scheibenförmigen Substrates mit einem maximalen Durchmesser von mindestens 100 mm, vorzugsweise von mindestens 150 mm, vorzugsweise gar von 200 mm oder gar von 300 mm, ausgebildet sein.

Dabei erzeugt die erfindungsgemässe Anordnung in bevorzugter Ausführungsform in und entlang der erwähnten Positionierungsebene der Substrathalterung, insbesondere entlang Flächen entsprechend den eben angegebenen Substratdimensionen, ein Magnetfeld mit kolinearen Feldlinien, die höchstens $\pm$ 5°, vorzugsweise höchstens $\pm$ 3°, vorzugsweise gar höchstens $\pm$ 2° von idealer Kolinearität bzw. Parallelität abweichen.

Eine erfindungsgemässe Beschichtungsanlage zeichnet sich nach dem Wortlaut von Anspruch 18 aus. Sie weist für die Aufnahme mindestens eines zu beschichtenden Substrates in der Beschichtungskammer eine Anordnung der vorbeschriebenen Art auf. In einer bevorzugten Ausführungsform weist die Beschichtungsanlage in der Kammer mindestens eine Sputterquelle auf mit einem Target aus magnetischem, vorzugsweise weichmagnetischem Material.

Ein erfindungsgemässes Substrat mit mindestens einer magnetischen Schicht zeichnet sich nach dem Wortlaut von Anspruch 22 aus. Dabei weist das erfindungsgemässe Substrat in einer bevorzugten Ausführungsform mindestens zwei magnetische Schichten auf mit je der erwähnten magnetischen Anisotropie bevorzugt in unterschiedlichen Richtungen.

Das erfindungsgemässe Verfahren zeichnet sich im weiteren nach dem Kennzeichen von Anspruch 20 aus.

Mit dem erfindungsgemässen Vorgehen lassen sich nicht nur magnetische Anisotropien äusserst exakt kolinear und grossflächig in magnetischen Substratschichten erzeugen, sondern es kann hinzukommend die Richtung dieser Anisotropie höchst einfach geändert werden, so dass an Substraten mit zwei und mehr magnetischen Schichten, jeweils in unterschiedlichen Richtungen, kolineare Anisotropien erzeugt werden können ohne Umpositionierung der Substrate während des Beschichtungsprozesses.

Die Forderung nach derartigen Substraten mit um 90° verschobenen kolinearen Anisotropien ergibt sich z.B. bei der Herstellung von magnetischen Sensoren, wie sie in sogenannten Dünnschichtköpfen für Festplatten, in der Sensorik des KFZ-Bereiches und in sogenannten MRAMs (Magnetic RAM, siehe z.B. Hubert Brückl, "Non-Volatile Memory", Magnetic Storage Industry Sourcebook, 1999) Verwendung finden. Im weiteren wird die erwähnte Forderung auch bei der Herstellung von Mehrlagen-Schichtsystemen, die nach dem "spin valve"-Prinzip (s. B. Ocker, W. Maass et al., "Spin Valves for High Density", Magnetic Storage) aufgebaut sind, gestellt.

Eine weitere Anwendung der Erfindung ist die magnetische Messtechnik, bei der z.B. die magnetischen Eigenschaften magnetischer Schichten oder Werkstoffe vermessen werden. Bei diesen Messungen ist es in vielen Fällen nötig, kolineare, homogene Magnetfelder in verschiedenen Richtungen an die zu messenden Proben anzulegen.

Das im oben erwähnten Zusammenhang erfindungsgemäss realisierte Vorgehen eignet sich somit gemäss erfindungsgemässer Verwendung für alle Einsatzzwecke, wo in einer bestimmten Ebene grossflächig eine bestimmte Magnetfeldverteilung erwünscht ist, dabei insbesondere wiederum eine homogene, kolineare Feldverteilung über grössere Flächenbereiche, wobei hierfür die genannte Ebene anstelle der obengenannten Positionierungsebene definiert wird.

Die Erfindung wird anschliessend beispielsweise anhand von Figuren erläutert. Es zeigen:

Fig. 1    Schematisch und in Minimalkonfiguration, eine erfindungsgemässe Anordnung zur Realisation des erfindungsgemässen Herstellungsverfahrens der erfindungsgemässen Substrate;

Fig. 2    schematisch, in Aufsicht, die Anordnung nach Fig. 1;

Fig. 3    in Aufsicht analog zur Darstellung von Fig. 2, eine bevorzugte Ausführungsform der erfindungsgemässen Anordnung für die Erzeugung grossflächiger, kolinearer Magnetfelder und damit -Anisotropien, selektiv Richtungs-umschaltbar;

Fig. 4    schematisch, die elektrische Beschaltung der Spulen an der Anordnung gemäss Fig. 3 bei gleicher Strombeaufschlagung unterschiedlich gewickelter Spulen;

Fig. 5    im Querschnitt, die Spulenanordnung bei Realisation nach Fig. 4, mit selektiv in Betrieb zu nehmenden Spulensätzen;

Fig. 6    in einer Abwicklungsdarstellung, im Querschnitt, die Wicklungsverhältnisse an Spulen bei der Realisation nach den Fig. 4 und 5 für die Richtungsumschaltung der realisierten Anisotropie;

Fig. 7    schematisch, die Realisation der Anordnung nach Fig. 3, mit Stromumschaltung zu den Spulen für Richtungswechsel der realisierten Anisotropie;

Fig. 8    an einem kreisscheibenförmigen, weichmagnetisch beschichteten Substrat die erfindungsgemäss realisierte magnetische Anisotropie, dargestellt an der einen Hälfte des Substrates;

Fig. 9    einen Ausschnitt einer weiteren bevorzugten Ausführungsform der erfindungsgemässen Anordnung, und

Fig. 10   den Querschnitt eines bevorzugt ausgeformten, an der Anordnung gemäss Fig. 9 eingesetzten Flussführungsstückes.

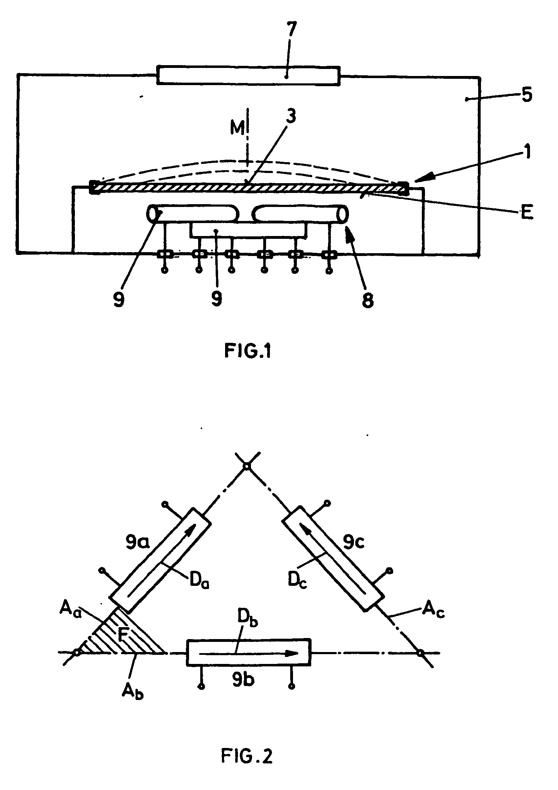

In Fig. 1 ist, schematisch und in Seitensicht, eine erfindungsgemässe Anordnung zur Magnetisierung dünner Schichten dargestellt, in Minimalkonfiguration. In Aufsicht ist die Anordnung in Fig. 2 dargestellt. Die erfindungsgemässe Anordnung umfasst eine Substrathalterung 1, woran - wie gestrichelt dargestellt - gebogene, in bevorzugter Anwendungsform aber insbesondere plane Substrate 3 gehaltert werden. Jedenfalls definiert die Substrathalterung 1 eine Positionierungsebene E für wie auch immer geformte Substrate 3. Die Halterung 1 ist dabei, im Einsatz, Teil einer Vakuumbeschichtungskammer 5 mit einer in Fig. 1 schematisch dargestellten Beschichtungsquelle 7, bevorzugt einer Sputterquelle, insbesondere einer Magnetronsputterquelle.

Unterhalb der Positionierungsebene E, definiert durch die Substrathalterung 1, ist die erfindungsgemässe Magnetanordnung 8 vorgesehen. Sie umfasst mindestens drei Elektromagnete 9 mit den ihren Spulen zugeordneten elektrischen Anschlüssen, wie insbesondere in Fig. 2 schematisch dargestellt ist.

Gemäss Fig. 2 definiert jeder Elektromagnet 9a bis 9c einen magnetischen Dipol, entsprechend $D_a$ bis $D_c$, welch letztere wiederum magnetische Dipol-Achsen $A_a$ bis $A_c$ definieren. Wie sich aus Fig. 1 ohne weiteres ergibt, brauchen die Elektromagnete 9 nicht zwingend, mit ihren Dipol-Achsen A, in einer Ebene zu liegen, was aber weitaus bevorzugt ist. Liegen sie nicht in einer Ebene, wie in Fig. 1 dargestellt, so kann durchaus der Einfluss unterschiedlicher Abstände zur Ebene E durch das an den jeweiligen Elektromagneten 9 erzeugte Magnetfeld kompensiert werden.

Wie in Fig. 2 aber ersichtlich, umranden die Dipol-Achsen A der vorgesehenen Elektromägnete 9 in Aufsicht auf die Positionierungsebene E jedenfalls eine in sich geschlossene Fläche F.

Ausgehend von der Minimalkonfiguration nach Fig. 1 werden bevorzugterweise

• mehr als drei Elektromagnete vorgesehen, bei deren Anzahl n, die Dipol-Achsen $A_{1-n}$, in der Ansicht gemäss Fig. 2 ein n-Eck, vorzugsweise ein regelmässiges n-Eck, aufspannen.

• Im weiteren werden die Elektromagnete jeweils durch Spulen gebildet, welche gemeinsam auf einen die Fläche F gemäss Fig. 2 umschlingenden Magnetkern, dabei bevorzugt Ringkern, gewickelt sind.

Obwohl die Figuren 1 und 2 im Zusammenhang mit der Realisation einer erwünschten Anisotropie-Verteilung, insbesondere einer kolinearen, an einer oder mehreren magnetischen Schichten eines Substrates erläutert worden sind, geht ohne weiteres insbesondere für den Fachmann hervor, dass Bedingung der Realisation einer derartigen Anisotropie-Verteilung ist, in der Ebene E eine entsprechende Magnetfeldverteilung, insbesondere eine kolineare homogene Magnetverteilung, zu erzielen. Damit kann nun diese und die nachfolgend beschriebene Vorrichtung überall dort eingesetzt werden, wo entsprechend grossflächig - wie noch zu erläutern sein wird - eine homogene kolineare Magnetfeldverteilung in einer Ebene entsprechend E erwünscht ist, welche bezüglich ihrer Richtung auf einfache Art und Weise eingestellt werden kann.

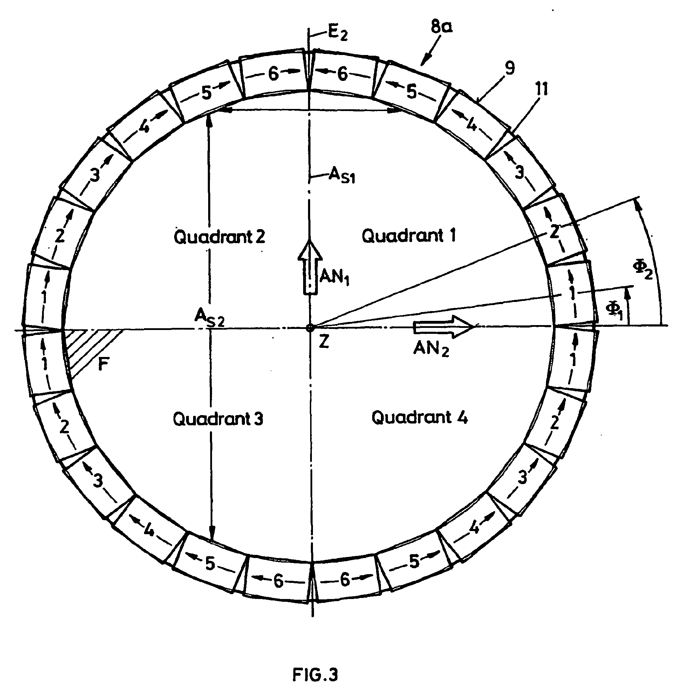

In Fig. 3 ist eine bevorzugte Realisationsform der erfindungsgemässen Magnetanordnung 8a bzw. deren Elektromagnete 9 in Ansicht gemäss Fig. 2 dargestellt, insbesondere für die Realisation einer magnetischen Anisotropie an einer magnetischen, beispielsweise gemäss Fig. 1 aufgesputterten Schicht, mit weitgehendst über die ganze Substratausdehung kolinearen Feldlinien, mit einer Winkelabweichung von idealer Parallelität von höchstens $\pm$ 5°, vorzugsweise von höchstens $\pm$ 3°, vorzugsweise gar von höchstens $\pm$ 2°.

Die in Fig. 3 dargestellte Magnetanordnung umfasst eine gerade Anzahl Magnete 9, gebildet durch Spulen auf einem gemeinsamen Ringkern 11. Mit Z ist das Zentrum der Magnetanordnung - hier des Ringkernes - dargestellt, welches, bei der Beschichtung von zentrischen Substraten, wie insbesondere kreisförmiger oder rechteckförmiger bzw. quadratischer, in der in Fig. 1 bei M angedeuteten Zentrumsachse des Substrates 3 liegt.

Werden an der Substrathalterung 1 gemäss Fig. 1 mehr als ein Substrat angeordnet, so bevorzugterweise zentrisch um die Achse M und entsprechend, mit Blick auf Fig. 3, um die Achse Z gruppiert.

Wie aus Fig. 3 ersichtlich, sind die Spulen der Magnete 9 pro Quadrant mit den Nr. 1 bis 6 durchnumeriert. Im weiteren sind in Fig. 3 die bevorzugt eingesetzten Dipolrichtungen eingetragen. Wie ersichtlich, wird die gerade Anzahl gesamthaft vorgesehener Elektromagnete 9 durch eine Ebene $E_2$, welche die Achse Z enthält und wovon in Fig. 3 lediglich die Achse $A_{s1}$ ersichtlich ist, in zwei Gruppen geteilt werden. Jede der Gruppen, nämlich einerseits der in den Quadranten 1 und 4 enthaltenen Elektromagnete 9 sowie, anderseits, der in den Quadranten 2 und 3 enthaltenen Magnete 9, erzeugen Dipole mit einer Richtungskomponente parallel zu den Ebenen $E_2$ und E (gemäss Fig. 1), welche an beiden Gruppen gleichgerichtet sind.

Dipol-Richtungskomponenten senkrecht zur erwähnten, also in Richtung $AN_2$ gemäss Fig. 3, d.h. senkrecht zur Ebene $E_2$ sind aber in der einen Gruppe $G_{41}$, für die Quadranten 1 und 4 invers zu den entsprechenden Richtungskomponenten der Dipole in der Gruppe $G_{32}$ mit den Quadranten 2 und 3 gerichtet. Im weiteren werden die Beträge der erwähnten Dipole unterschiedlich gross ausgelegt, was durch Vorsehen unterschiedlicher Windungszahlen an den Spulen der Elektromagnete 9 und/oder durch Ansteuerung der Elektromagnetspulen gleicher oder unterschiedlicher Windungszahlen mit entsprechend bemessenen unterschiedlichen Strömen realisiert wird. In der in Fig. 3 dargestellten Ausführungsform sind die Beträge der magnetischen Dipole an den Gruppen zugeordneter Elektromagnetspulen wie ersichtlich bezüglich der Ebene $E_2$ bzw. der Achse $A_{s1}$ spiegelbildlich gewählt.

In der nachfolgenden Tabelle sind die Spulen wie folgt numeriert:

$$Q_{x,y},$$

worin x die Quadrantennummer und y die Spulennummer gemäss Fig. 3 bezeichnet.

Normiert auf den Betrag der geringsten Spulenfeldstärke in einem Quadranten sind in der nachfolgenden Tabelle - für die Erzeugung einer Anisotropie in Richtung $\phi$ = 0°, d.h. in Richtung von AN2 in Fig. 3 sowie für eine diesbezüglich um 90° gedrehte Anisotropie-Richtung, gemäss AN1 - die pro Spule zu erzeugenden Feldstärke-Beträge bzw. Dipolstärken zusammengestellt.

Bevorzugterweise werden die Beträge und Richtungen der magnetischen Dipole, mit $\phi$ als polarer Ortskoordi-nate der jeweiligen betrachteten Elektromagnetspule, mindestens genähert proportional zur Funktion $\cos\phi$ ausgelegt.

Die unterschiedlichen Feldstärke-Beträge und damit Dipol-Werte an den jeweiligen Spulen können - wie erwähnt - durch Vorsehen unterschiedlicher Wicklungszahlen an den Spulen, entsprechend den in genannter Tabelle zusammengestellten Gewichtungsfaktoren, realisiert werden und/oder durch Beaufschlagung der Spulen mit den Gewichtungsfaktoren entsprechenden Strömen. Bevorzugterweise werden entweder Spulen mit gleichen Windungszahlen und Gewichtung durch Beaufschlagung mit unterschiedlichen Strömen gewählt oder Spulen mit unterschiedlichen Windungszahlen, beaufschlagt mit gleichen Strömen. Eine Mischform ist aber durchaus möglich.

**Tabelle 1**

| Quadrant Nr. Spulen Nr. | Anisotropie-Richtung bei $\phi$ = 0° | Anisotropie-Richtung bei $\phi$ = 90° |
|---|---|---|
| $Q_{11} = Q_{21} = Q_{31} = Q_{41}$ | 1 | 7,56 |
| $Q_{12} = Q_{22} = Q_{32} = Q_{42}$ | 2,92 | 7,05 |
| $Q_{13} = Q_{23} = Q_{33} = Q_{43}$ | 4,65 | 6,05 |
| $Q_{14} = Q_{24} = Q_{34} = Q_{44}$ | 6,05 | 4,65 |
| $Q_{15} = Q_{25} = Q_{35} = Q_{45}$ | 7,05 | 2,92 |
| $Q_{16} = Q_{26} = Q_{36} = Q_{46}$ | 7,56 | 1 |

Es ist nun ohne weiteres ersichtlich, dass durch Umsteuerung der die Spulen der Elektromagnete 9 beschik-

7

kenden Ströme die Lage der Ebene $E_2$ gemäss Fig. 3 gedreht werden kann. Erfolgt beispielsweise die Gewichtung der Dipole durch entsprechende Strombemessung so, dass für die erwähnte $\cos\phi$-Funktion der Nullwinkel bei $\phi_2$ liegt, ergibt sich eine entsprechende Dipol-Polaritätsumkehr an den Spulen $Q_{25}$, $Q_{26}$ und $Q_{46}$, $Q_{45}$, mit dem Ergebnis einer Schwenkung der Richtung des kolinearen Feldes und damit auch der erzeugten kolinearen Anisotropie um $\phi_2$. Durch Umsteuerung der die Spulen ansteuernden Stromgeneratoren kann die erwähnte Richtung in einzelnen, vorgewählten Schritten oder, von Spule zu Spule inkrementell, von 0° bis 360° bezüglich der Achse Z elektrisch umgesteuert werden.

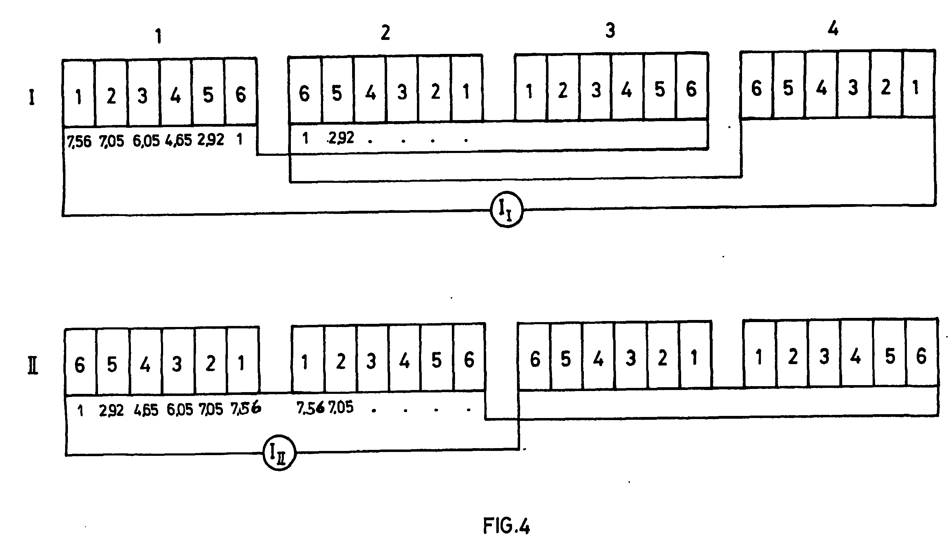

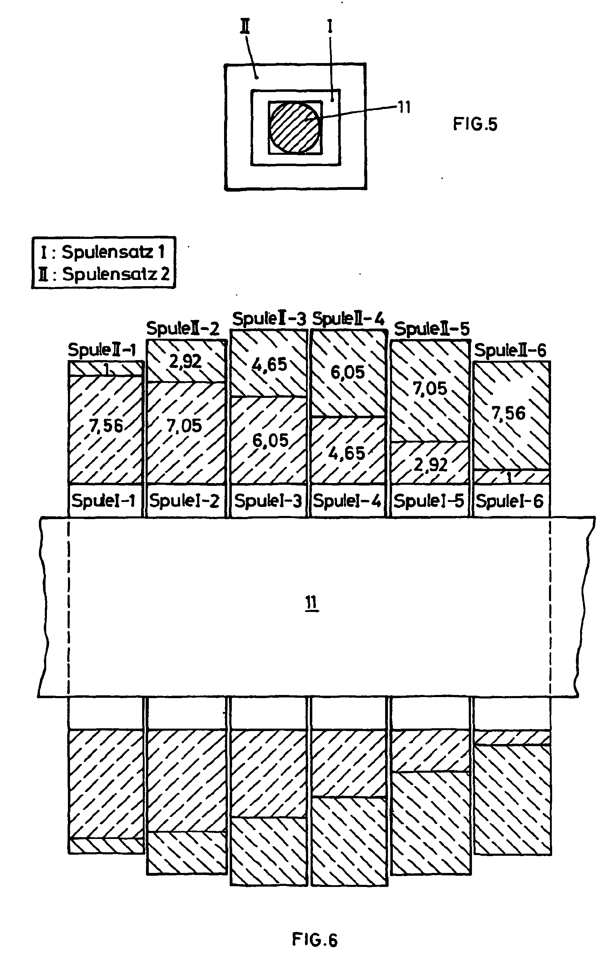

Eine weitere Realisationsform ist in den Figuren 4 und 5 dargestellt.

Bei dieser Realisationsform ist die Umschaltung der Anisotropie-Richtung, beispielsweise von AN1 auf AN2 gemäss Fig. 3, dadurch zu realisieren, dass auf denselben Kern 11 gemäss Fig. 3, bevorzugterweise koaxial zur Kernachse, jeweils zwei, ggf. - für mehr als zwei umschaltbare Anisotropie-Richtungen - mehr als zwei Spulen gewickelt werden. Schematisch ist dies in Fig. 5 dargestellt, mit Ringkern 11 im Querschnitt und Spule des Satzes I und koaxial hierzu Spule des Satzes II.

Die Wicklungszahlen für die Spulen und deren Beschaltung ergeben sich aus Fig. 4

In Fig. 6 ist dies schematisch für einen der Quadranten dargestellt. Die in obiger Tabelle angegebenen Gewichtungsfaktoren sind auch hier eingetragen.

Das zweite Prinzip in Reinform ist dasjenige der Stromgewichtung bei Spulen mit gleicher Wicklungszahl.

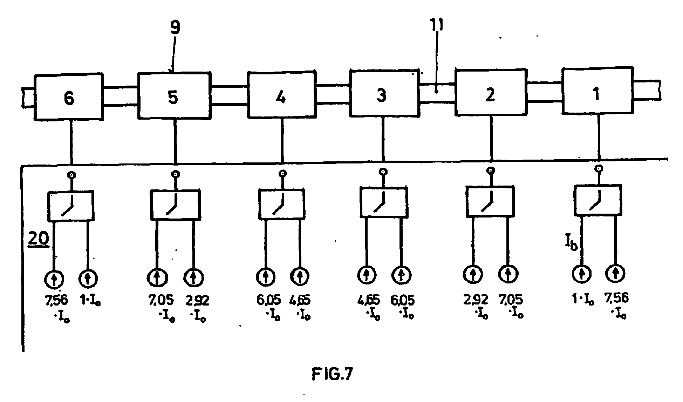

Gemäss Fig. 7 werden in diesem Fall die Spulen über eine Stromverteilelektronik 20 mit den gewichteten Stromwerten versorgt. Es muss betont werden, dass sich für die Realisation der Stromumschaltung an der Einheit 20 dem Fachmann viele Möglichkeiten eröffnen, und dass die in Fig. 7 in Analogie zu der Tabelle aufgeführten Gewichtungsfaktoren nur erläuternden Charakter haben sollen.

Bei diesem Vorgehen ist die Umschaltung von der Erzeugung der einen Anisotropie-Richtung, beispielsweise AN1, zur zweiten, beispielsweise AN2 gemäss Fig. 3, ohne einen zweiten Spulensatz vorsehen zu müssen einfach, indem lediglich die Spulenströme umgeschaltet werden.

Anstelle von sechs Spulen pro Quadrant können selbstverständlich je nach Anforderungen an die zu erzielende Genauigkeit der IST-Anisotropie-Verteilung bezüglich einer vorgegebenen SOLL-Anisotropie-Verteilung mehr oder weniger Spulen vorgesehen werden.

Mit der in Fig. 3 dargestellten Anordnung, dimensioniert nach der Tabelle und mit Aussendurchmesser $\theta$ = 450 mm, wurden kreisscheibenförmige Substrate mit Durchmesser $\theta_s$ = 150 mm und $\theta_s$ = 200 mm während der Herstellung einer Schicht aus Permalloy magnetisiert. Es wurden Spulen gleicher Wicklungszahl eingesetzt, mit unterschiedlichen Stromstärken und Stromrichtungen in den Einzelspulen.

Die Stromstärken wurden im wesentlichen gemäss den in der Tabelle angegebenen Gewichtungsfaktoren realisiert. Der Abstand zwischen den in einer Ebene liegenden Dipolachsen zu der beschichteten Oberfläche der planen kreisscheibenförmigen Substrate betrug 70 mm. Die Substrate bestanden aus Silizium.

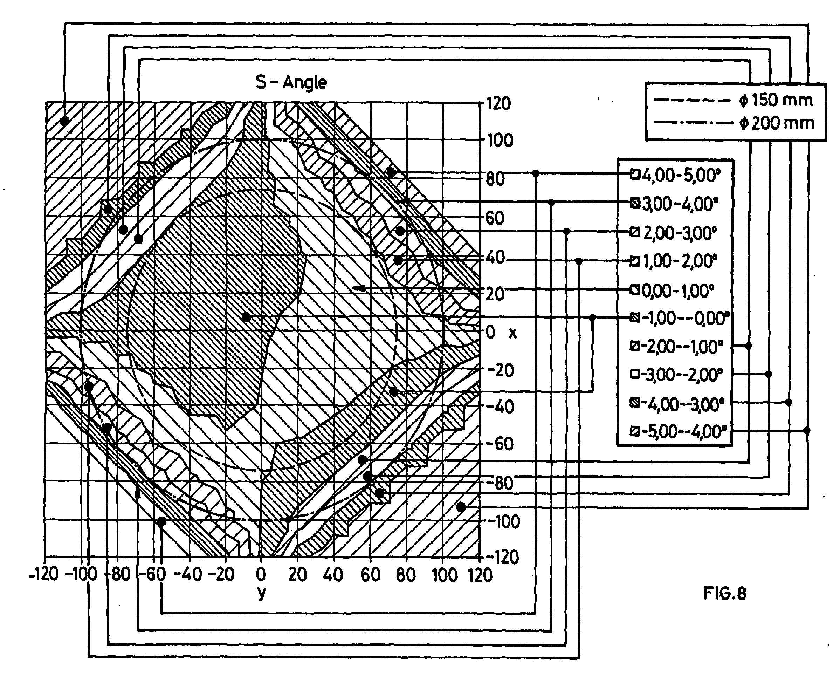

In Fig. 8 ist die gemessene Richtung der Feldlinien als Funktion des Ortes dargestellt. Entsprechend ergibt sich eine für Substrate mit $\theta_s$ = 150 mm eine maximale Abweichung der Anisotropie-Richtung von der SOLL-Richtung von höchstens $\pm$ 1°.

Für $\theta_s$ = 200 mm-Substrate wird die maximale Abweichung höchstens $\pm$ 3°.

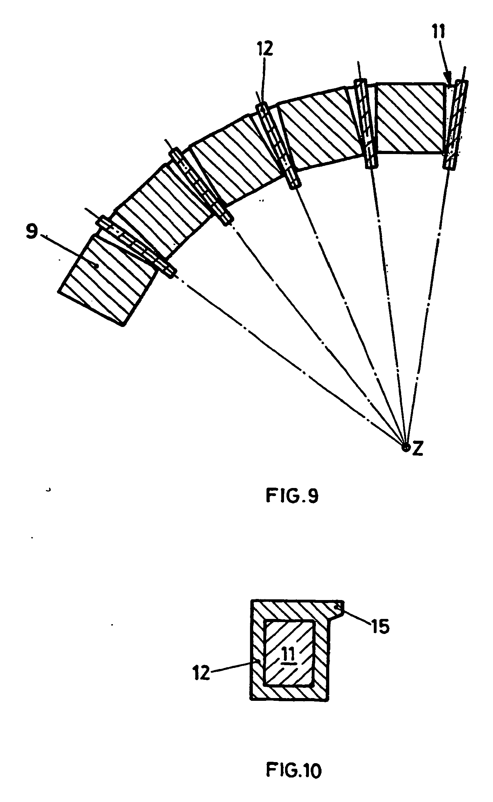

In Fig. 9 ist der Ausschnitt einer weiteren bevorzugten Ausführungsform der erfindungsgemässen Anordnung dargestellt. Dabei sind Spulen 9 in einer der bis anhin beschriebenen Arten auf einen Ringkern 11 gewickelt. Zwischen den Spulen 9 sind Flussführungsstücke 12 aus Eisen gemäss Fig. 10 aufgesetzt. Sie weisen jeweils gegen das Zentrum Z gerichtete Flussführungsnasen 15 auf. Durch Vorsehen dieser Flussführungsstücke 12 wird bei ansonsten gleichen Strömen durch die Spulen 9 ein stärkeres Magnetfeld erreicht, welches aber ebenfalls die erwünschte kolineare Anisotropie bzw. kolineare Anisotropie-Verteilung aufweist.

Durch die vorgeschlagene Technik wird es möglich, insbesondere kolineare Magnetfelder relativ zu einem Substrat ohne mechanische Vorrichtungen zu drehen. An Substraten werden kolineare Feldbereiche erzielt, entlang der wesentlichsten Substratflächenbereiche, und dies an grossflächigen Substraten oder kreisscheibenförmigen bzw. quadratischen.

**Patentansprüche**

1. Anordnung zur Ausrichtung der Magnetisierungsrichtung magnetischer Schichten auf scheibenförmigen Substraten mit

   • einer Substrathalterung (1) für mindestens ein Substrat (3), die eine Positionierungsebene (E) für das mindestens eine Substrat definiert,
   • einer Magnetanordnung auf einer Seite der Positionierungsebene (E),

**dadurch gekennzeichnet, dass** die Magnetanordnung mindestens drei Elektromagnete (9) umfasst, deren Dipol-Achsen (A) mindestens genähert parallel zur Positionierungsebene (E) liegen und, senkrecht zur Positionierungsebene betrachtet, eine geschlossene Fläche (F) aufspannen.

2. Anordnung nach Anspruch 1, **dadurch gekennzeichnet, dass** die Dipol-Achsen (A) ein vorzugsweise regelmässiges n-Eck als Fläche (F) aufspannen und/oder vorzugsweise in einer Ebene parallel zur Positionierungsebene (E) liegen, dabei weiter vorzugsweise mehr als drei Elektromagnete vorgesehen sind, wobei n die Anzahl Elektromagnete (9) ist.

3. Anordnung nach einem der Ansprüche 1 oder 2, **dadurch gekennzeichnet, dass** eine gerade Anzahl Elektromagnete (9) vorgesehen ist, vorzugsweise eine durch 4 teilbare Anzahl.

4. Anordnung nach einem der Ansprüche 1 bis 3, **dadurch gekennzeichnet, dass** die Magnetanordnung zwei Elektromagnetgruppen umfasst, woran Elektromagnete je wie folgt gerichtete Dipole erzeugen:

   • die Dipole haben erste Komponenten, parallel zur Positionierungsebene und in einer ersten Richtung, die bei beiden Gruppen gleichgerichtet sind,
   • die Dipole haben zweite Komponenten, parallel zur Positionierungsebene und in zur ersten senkrechter Richtung, die bei der einen Gruppe invers zu denjenigen der zweiten Gruppe gerichtet sind.

5. Anordnung nach einem der Ansprüche 1 bis 4, **dadurch gekennzeichnet, dass** die Elektromagnete (9) durch Spulen gebildet sind, gewickelt auf einem gemeinsamen, die Fläche (F) umschlingenden Magnetkern (11), vorzugsweise Ringkern.

6. Anordnung nach einem der Ansprüche 1 bis 5, **dadurch gekennzeichnet, dass** die Elektromagnete (9) durch Spulen gebildet sind, die mindestens teilweise unterschiedliche Wicklungszahlen aufweisen.

7. Anordnung nach einem der Ansprüche 1 bis 6, **dadurch gekennzeichnet, dass** die Elektromagnete mit Stromgeneratoren verbunden sind, die die Elektromagnete mit DC- oder AC- oder DC+AC-Strom beschicken, sofern mindestens auch mit AC-Strom, dann bevorzugt mit einer Frequenz f, für die gilt

$$1 \, \text{Hz} \leq f \leq 100 \, \text{Hz}.$$

8. Anordnung nach einem der Ansprüche 1 bis 7, **dadurch gekennzeichnet, dass** mindestens ein Teil der Elektromagnete an Stromgeneratoren angeschlossen sind, die die Elektromagnete mit Strömen beschicken, für die gilt

   • DC-Werte sind unterschiedlich und/oder
   • AC-Amplituden und/oder Phasen sind unterschiedlich.

9. Anordnung nach einem der Ansprüche 1 bis 8, **dadurch gekennzeichnet, dass** die Elektromagnete an einer Stromgeneratoranordnung angeschlossen sind, woran die Verteilung von Ausgangsströmen zu den Elektromagneten in mindestens zwei unterschiedliche Verteilungs-Zustände umschaltbar ist.

10. Anordnung nach einem der Ansprüche 1 bis 9, **dadurch gekennzeichnet, dass** die Elektromagnete Spulen auf einem gemeinsamen Ringkern umfassen, vorzugsweise eine gerade Anzahl, insbesondere bevorzugt eine durch vier teilbare Anzahl, und dass eine Symmetrieebene, die die Achse (Z) des Kernes enthält, die Spulen in zwei Gruppen teilt, wobei erste Richtungskomponenten der Dipole der Spulen beider Gruppen in Richtung parallel zur Symmetrieebene gleichgerichtet sind und zweite Richtungskomponenten der Dipole zu den ersten Richtungskomponenten senkrecht stehen, wobei die zweite Richtungskomponenten bei der einen Gruppe von Spulen invers zu denjenigen der zweiten Gruppe von Spulen gerichtet sind, und die Dipole eine Stärke aufweisen mindestens genähert proportional zu $\cos\phi$, wobei $\phi$ der Polarlage-Winkel einer jeweiligen Spule bezüglich der Achse (Z) des Ringkernes ist.

11. Anordnung nach Anspruch 10, **dadurch gekennzeichnet, dass** durch Umschalten der Verteilung von die Spulen durchfliessenden Strömen die Winkellage der Symmetrieebene um die Achse (Z) schwenkbar ist in vorgegebene Winkellagen und/oder im Bereich 0° - 360° in Schritten frei wählbar.

**12.** Anordnung nach einem der Ansprüche 1 bis 11, **dadurch gekennzeichnet, dass** mindestens zwei der Magnetanordnungen umfassend je einen Elektromagnet- resp. Spulensatz (I, II) vorgesehen sind.

**13.** Anordnung nach Anspruch 12, **dadurch gekennzeichnet, dass** bezüglich einer Achse senkrecht zur Positionierungsebene die Elektromagnet- resp. Spulensätze (I, II) koaxial angeordnet sind, vorzugsweise gleich sind und bezüglich der Achse (Z) gegenseitig um einen Winkel, vorzugsweise von $\pi/2$, verdreht sind, betrachtet in einer Ebene senkrecht zur Achse.

**14.** Anordnung nach einem der Ansprüche 12 oder 13, **dadurch gekennzeichnet, dass** Spulen beider Magnetanordnungen auf denselben Kern, vorzugsweise Ringkern, gewickelt sind.

**15.** Anordnung nach einem der Ansprüche 1 bis 14, **dadurch gekennzeichnet, dass** die Substrathalterung (1) zur Aufnahme mindestens eines scheibenförmigen, vorzugsweise rechteckförmigen oder - und besonders bevorzugt - kreisförmigen Substrates ausgebildet ist und vorzugsweise die Magnetanordnung oder die Magnetanordnungen symmetrisch zu einer Zentrumsachse durch die Substrathalterung angeordnet ist bzw. sind.

**16.** Anordnung nach einem der Ansprüche 1 bis 15, **dadurch gekennzeichnet, dass** die Substrathalterung (1) für die Aufnahme mindestens eines scheibenförmigen Substrates mit einem maximalen Durchmesser von mindestens 100 mm, vorzugsweise von mindestens 150 mm, vorzugsweise gar von 200 mm oder gar von 300 mm, ausgebildet ist.

**17.** Anordnung nach einem der Ansprüche 1 bis 16, **dadurch gekennzeichnet, dass** die mindestens eine Magnetanordnung in und entlang der Positionierungsebene (E) der Substrathalterung ein kolineares Magnetfeld erzeugt mit Feldlinien, die höchstens $\pm$ 5°, vorzugsweise höchstens $\pm$ 3°, vorzugsweise gar höchstens $\pm$ 2° von idealer Parallelität abweichen.

**18.** Vakuumbeschichtungsanlage mit einer Beschichtungskammer (5), **dadurch gekennzeichnet, dass** eine Anordnung nach einem der Ansprüche 1 bis 17 für die Aufnahme mindestens eines zu beschichtenden Substrates (3) in der Kammer (5) vorgesehen ist.

**19.** Vakuumbeschichtungsanlage nach Anspruch 18, **dadurch gekennzeichnet, dass** in der Kammer (5) mindestens eine Sputterquelle (7) vorgesehen ist mit einem Target aus magnetischem, vorzugsweise weichmagnetischem Material.

**20.** Verfahren zur Herstellung von Substraten mit mindestens einer Schicht aus weichmagnetischem Material sowie einer SOLL-Verteilung der magnetischen Anisotropie in der Schicht, bei dem man während dem Aufbringen der Schicht diese dem Magnetfeld einer Elektromagnetanordnung aussetzt, **dadurch gekennzeichnet, dass** man, ausgehend von einer erwünschten SOLL-Verteilung der magnetischen Anisotropie, das Magnetfeld mittels einer Anordnung nach einem der Ansprüche 1 bis 17 erzeugt.

**21.** Verfahren nach Anspruch 20, **dadurch gekennzeichnet, dass** man die gewünschte SOLL-Anisotropie-Verteilung durch Einstellung der die Elektromagnete je durchfliessenden Ströme und/oder durch Aktivieren von Elektromagnetspulen mit bestimmten Windungszahlen einstellt.

**22.** Kreisförmiges Substrat mit mindestens einer magnetischen Schicht und mit einem Durchmesser von mindestens 200 mm bzw. wobei gar von mindestens 300 mm, wobei die magnetische Schicht eine kolineare magnetische Anisotropie-Richtung hat mit einer Winkelabweichung von höchstens $\pm$ 5°, vorzugsweise von höchstens $\pm$ 3°, insbesondere von höchstens $\pm$ 2°, **dadurch gekennzeichnet, dass** das Substrat mittels des Verfahrens nach einem der Ansprüche 20 oder 21 hergestellt ist.

**23.** Substrat, vorzugsweise kreisförmig, mit einem maximalen Durchmesser von mindestens 100 mm, vorzugsweise von mindestens 150 mm, insbesondere bevorzugt von mindestens 200 mm bzw. gar von 300 mm, versehen mit mindestens zwei übereinanderliegenden magnetischen Schichten, wobei die magnetischen Schichten je eine kolineare magnetische Anisotropie-Richtung aufweisen je mit einer Winkelabweichung von höchstens $\pm$ 5°, vorzugsweise von höchstens $\pm$ 3°, insbesondere von höchstens $\pm$ 2°, wobei bevorzugterweise die Anisotropien der Schichten verschiedene Richtungen haben, **dadurch gekennzeichnet, dass** das Substrat mittels des Verfahrens nach einem der Ansprüche 20 oder 21 hergestellt ist.

**24.** Verwendung der Anordnung nach einem der Ansprüche 1 bis 17 zur Erzeugung eines kolinearen Magnetfelds in einer vorgegebenen Ebene, wobei man anstelle der Positionierungsebene die vorgegebene Ebene setzt.

25. Verwendung nach Anspruch 24 zu Messzwecken.

**Claims**

1.  Arrangement for aligning the magnetization direction of magnetic layers on plate-form substrates with

    • a substrate mounting (1) for at least one substrate (3), which defines a positioning plane (E) for the at least one substrate,
    • a magnet arrangement on one side of the positioning plane (E),

    **characterized in that** the magnet arrangement comprises at least three electromagnets (9), whose dipole axes (A) are at least approximately parallel to the positioning plane (E) and, viewed perpendicularly to the positioning plane, define a closed surface (F).

2.  Arrangement of claim 1, **characterized in that** the dipole axes (A) define a preferably regular n-polygon as surface (F) and/or are preferably in a plane parallel to the positioning plane (E), further preferably more than three electromagnets are provided with n being the number of electromagnets (9).

3.  Arrangement of one of claims 1 or 2, **characterized in that** an even number of electromagnets (9) is provided, preferably a number divisible by 4.

4.  Arrangement of one of claims 1 to 3, **characterized in that** the magnet arrangement comprises two electromagnet groups, at which electromagnets generate dipoles directed as follows:

    • the dipoles have first components, parallel to the positioning plane and in a first direction, which in both groups are directed alike,
    • the dipoles have second components, parallel to the positioning plane and in the direction perpendicular to the first, which in the one group are directed inversely to those of the second group.

5.  Arrangement of one of claims 1 to 4, **characterized in that** the electromagnets (9) are formed by coils wound onto a common magnetic core (11), preferably a toroidal core, enwrapping the surface (F).

6.  Arrangement of one of claims 1 to 5, **characterized in that** the electromagnets (9) are formed by coils which have at least partially different winding numbers.

7.  Arrangement of one of claims 1 to 6, **characterized in that** the electromagnets are connected to current generators which feed the electromagnets with DC or AC or DC+AC current, if at least also with AC current, then preferably at a frequency f, to which applies

$$1 \text{ Hz} \leq f \leq 100 \text{ Hz}.$$

8.  Arrangement of one of claims 1 to 7, **characterized in that** at least a portion of the electromagnets are connected to current generators which feed the electromagnets with currents, to which applies

    • DC values are different and/or
    • AC amplitudes and/or phases are different.

9.  Arrangement of one of claims 1 to 8, **characterized in that** the electromagnets are connected to a current generator arrangement on which the distribution of output currents to the electromagnets are switched into at least two different distribution states.

10. Arrangement of one of claims 1 to 9, **characterized in that** the electromagnets comprise coils on a common toroidal core, preferably an even number, especially preferred a number divisible by four, and that a plane of symmetry, which contains the axis (Z) of the core, divides the coils into two groups, in which first direction components of the dipoles of the coils of both groups are directed alike in a direction parallel to the plane of symmetry and second direction components of the dipoles are perpendicular to the first direction components, wherein the second direction components of the one group of coils are directed inversely to those of the second group of coils, and the dipoles have a strength at least approximately proportional to $\cos\phi$, with $\phi$ being the polar position angle of a particular coil with respect to axis (Z) of the toroidal core.

11. Arrangement of claim 10, **characterized in that** by switching over the distribution of currents flowing through the coils the angular position of the plane of symmetry is pivotable about axis (Z) into predetermined angular positions and/or in a range from 0° to 360° in freely selectable steps.

12. Arrangement of one of claims 1 to 11, **characterized in that** at least two of the magnet arrangements each comprising an electromagnet set or coil set (I, II) are provided.

13. Arrangement of claim 12, **characterized in that** with respect to an axis perpendicular to the positioning plane the electromagnet sets or coil sets (I, II) are disposed coaxially, preferably are identical and, with respect to the axis (Z), are rotated about an angle, preferably of $\pi/2$, viewed in a plane perpendicular to the axis.

14. Arrangement of one of claims 12 or 13, **characterized in that** coils of both magnet arrangements are wound on the same core, preferably a toroidal core.

15. Arrangement of one of claims 1 to 14, **characterized in that** the substrate mounting (1) is developed for receiving at least one plate-form, preferably rectangular or - and especially preferred - circular, substrate and the magnet arrangement or the magnet arrangements is/are disposed symmetrically to a center axis through the substrate mounting.

16. Arrangement of one of claims 1 to 15, **characterized in that** the substrate mounting (1) is adapted to receive at least one plate-form substrate with a maximum diameter of at least 100 mm, preferably of at least 150 mm, preferably even of 200 mm or even of 300 mm.

17. Arrangement of one of claims 1 to 16, **characterized in that** the at least one magnet arrangement generates in and along the positioning plane (E) of the substrate mounting a collinear magnetic field with field lines which deviate from ideal parallelity by maximally $\pm5°$, preferably maximally $\pm3°$, preferably even maximally $\pm2°$.

18. Vacuum coating installation with a coating chamber (5), **characterized in that** an arrangement of one of claims 1 to 17 is provided in the chamber (5) for receiving at least one substrate (3) to be coated.

19. Vacuum coating installation of claim 18, **characterized in that** in the chamber (5) at least one sputter source (7) is provided with a target comprised of magnetic, preferably soft magnetic material.

20. Method of producing substrates with at least one layer comprised of soft magnetic material as well as a nominal distribution of the magnetic anisotropy in the layer, in which during the application of the layer it is exposed to the magnetic field of an electromagnet arrangement, **characterized in that** based on a desired nominal distribution of the magnetic anisotropy the magnetic field is generated by means of an arrangement as claimed in one of claims 1 to 17.

21. Method of claim 20, **characterized in that** the desired nominal anisotropy distribution is set by setting the currents flowing through the electromagnets and/or by activating electromagnet coils with specific winding numbers.

22. Circular substrate with at least one magnetic layer, and with a maximum diameter of at least 200 mm or even of at least 300 mm, wherein the magnetic layer has a collinear magnetic anisotropy direction with an angular deviation of maximally $\pm5°$, preferably maximally $\pm3°$, especially of maximally $\pm2°$, **characterised in that** the substrate is produced using the method of one of claims 20 or 21.

23. Substrate, preferably circular, with a maximum diameter of at least 100 mm, preferably of at least 150 mm, especially preferred of at least 200 mm or even of 300 mm, provided with at least two superimposed magnetic layers, wherein the magnetic layers each have a collinear magnetic anisotropy direction, each with an angular deviation of maximally $\pm5°$, preferably maximally $\pm3°$, especially of maximally $\pm2°$, wherein preferably the anisotropies of the layers have different directions, **characterised in that** the substrate is produced using the method of one of claims 20 or 21.

24. Use of the arrangement of one of claims 1 to 17 for generating a collinear magnetic field in a predetermined plane, with the predetermined plane being set instead of the positioning plane.

25. Use of claim 24 for measuring purposes.

**Revendications**

1. Agencement pour l'alignement de la direction de magnétisation des couches magnétiques sur des substrats en forme de plaquette, ayant

   • un montage (1) de substrat pour au moins un substrat (3), qui définit un plan de positionnement (E) pour l'au moins un substrat,
   • un agencement d'aimants sur un coté du plan de positionnement (E),

   **caractérisé en ce que** l'agencement d'aimants comprend au moins trois électroaimants (9), dont les axes de dipôle (A) se situent au moins approximativement parallèles au plan de positionnement (E) et, considérés perpendiculaire au plan de positionnement, définissent une surface fermée (F).

2. Agencement selon la revendication 1, **caractérisé en ce que** les axes de dipôle (A) définissent comme surface (F) un polygone à n cotés, de préférence un polygone régulier, et/ou se situent de préférence dans un plan parallèle au plan de positionnement (E), de préférence également plus que trois électroaimants étant prévus, où n est le nombre d'électroaimants (9).

3. Agencement selon l'une des revendications 1 ou 2, **caractérisé en ce qu'**un nombre pair d'électroaimants (9) est prévu, de préférence un nombre divisible par 4.

4. Agencement selon l'une des revendications 1-3, **caractérisé en ce que** l'agencement d'aimants comprend deux groupes d'électroaimants, où les électroaimants génèrent des dipôles comme suit:

   • les dipôles possèdent des premiers composants parallèles au plan de positionnement et dans une première direction, qui sont dirigés dans la même direction pour les deux groupes,
   • les dipôles possèdent des seconds composants parallèles au plan de positionnement et dans une direction perpendiculaire à la première direction, qui sont dirigés pour l'un des groupes en direction inverse que pour le second groupe.

5. Agencement selon l'une des revendications 1-4, **caractérisé en ce que** les électroaimants (9) sont formés par des bobines embobinés autour d'un noyau d'aimant (11) commun, de préférence d'un noyau toroïdal, qui enlace la surface (F).

6. Agencement selon l'une des revendications 1-5, **caractérisé en ce que** les électroaimants (9) sont formés par des bobines comprenant au moins partiellement des nombres de tours différents.

7. Agencement selon l'une des revendications 1-6, **caractérisé en ce que** les électroaimants sont en connexion avec des génératrices de courant qui alimentent les électroaimants avec du courant DC ou AC ou DC+AC, si au moins ainsi avec du courant AC, ceci ayant de préférence une fréquence f, à laquelle s'applique

$$1 \text{ Hz} \leq f \leq 100 \text{ Hz.}$$

8. Agencement selon l'une des revendications 1-7, **caractérisé en ce qu'**au moins une partie des électroaimants sont en connexion avec des génératrices de courant alimentant les électroaimants avec du courant, pour lesquelles s'appliquent:

   • les valeurs DC sont différents et/ou

• les amplitudes et/ou phases AC sont différents.

9. Agencement selon l'une des revendications 1-8, **caractérisé en ce que** les électroaimants sont en connexion avec un agencement générateur de courant avec lequel la répartition des courants de sortie aux électroaimants est réglable en au moins deux états de répartition différentes.

10. Agencement selon l'une des revendications 1-9, **caractérisé en ce que** les électroaimants comprennent des bobines sur un noyau toroïdal commun, préférablement un nombre pair, plus préférablement un nombre divisible par quatre, et **en ce qu'**un plan de symétrie contenant l'axe (Z) du noyau divise les bobines en deux groupes, des premiers composants de direction de dipôle des deux groupes étant dirigés dans la même direction parallèle au plan de symétrie et des secondes composants de direction des dipôles étant perpendiculaires aux premiers composants de direction, les seconds composants de direction de l'un des groupes de bobines étant dirigés en direction inverse à ceux du second groupe de bobines, les dipôles présentant une intensité au moins approximativement proportionnelle à $\cos\phi$, où $\phi$ est l'angle du position polar de l'une des bobines particulières par rapport à l'axe (Z) du noyau toroïdal.

11. Agencement selon la revendication 10, **caractérisé en ce que** la position angulaire du plan de symétrie est pivotable autour de l'axe (Z) en positions angulaires prédéfinies et/ou peut être choisie librement dans une plage de 0° à 360° par commutation de la répartition des courants passant par les bobines.

12. Agencement selon l'une des revendications 1-11, **caractérisé en ce qu'**au moins deux des agencements d'aimants comprennent chacun un jeu d'électroaimants ou un jeu de bobines (I, II).

13. Agencement selon la revendication 12, **caractérisé en ce que** les jeux d'électroaimants ou les jeux de bobines sont agencé coaxialement par rapport à un axe perpendiculaire au plan de positionnement, sont préférablement identiques, et sont tournés respectivement par un angle, préférablement de $\pi/2$, considéré dans un plan perpendiculaire à l'axe.

14. Agencement selon l'une des revendications 12 ou 13, **caractérisé en ce que** des bobines des deux agencements d'aimants sont embobinées sur le même noyau, préférablement un noyau toroïdal.

15. Agencement selon l'une des revendications 1-14, **caractérisé en ce que** le montage (1) de substrat est agencé pour la réception d'au moins un substrat en forme de plaquette, préférablement carré ou - et particulièrement préféré - circulaire, et **en ce que** l'agencement d'aimants ou les agencements d'aimants est/sont préférablement agencé (s) symétriquement par rapport à un axe central passant à travers du montage de substrat.

16. Agencement selon l'une des revendications 1-15, **caractérisé en ce que** le montage de substrat (1) et agencé pour la réception d'au moins un substrat en forme de plaquette ayant un diamètre maximale d'au moins 100 mm, préférablement d'au moins 150 mm, préférablement même de 200 mm ou même de 300 mm.

17. Agencement selon l'une des revendications 1-16, **caractérisé en ce que** l'au moins un agencement d'aimants génère, colinéaire dans le, et au long du, plan de positionnement (E), un champ magnétique colinéaire ayant des lignes de champ qui divergent du parallélisme idéal par au maximum $\pm5°$, préférablement au maximum $\pm3°$, préférablement même $\pm2°$.

18. Installation de revêtement sous vide ayant une chambre (5) de revêtement, **caractérisée en ce qu'**elle comprend dans la chambre (5) un agencement selon l'une des revendications 1 à 17 pour la réception d'au moins un substrat (3) destiné à être traité.

19. Installation de revêtement sous vide selon la revendication 18, **caractérisée en ce qu'**au moins une source de pulvérisation (7) ayant une cible d'un matériau magnétique, de préférence d'un matériau magnétique doux, est prévue dans la chambre (5).

20. Procédé de fabrication des substrats comprenant au moins une couche de matériau magnétique doux ainsi qu'une distribution d'anisotropie magnétique nominale dans la couche, dans lequel on expose la couche au champ magnétique d'un agencement d'électroaimants pendant la période de déposition, **caractérisé en ce que**, basé sur une distribution d'anisotropie magnétique nominale désirée, on génère le champ magnétique par moyen d'un agencement selon l'une des revendications 1 à 17.

**21.** Procédé selon la revendication 20, **caractérisé en ce qu'**on règle la distribution d'anisotropie magnétique nominale désirée par le réglage des courants coulant à travers de chaque électroaimant et/ou par l'activation des bobines d'électroaimants comprenant des nombres de spires spécifiques.

**22.** Substrat circulaire comprenant au moins une couche magnétique et présentant un diamètre d'au moins 200 mm ou même d'au moins 300 mm, la couche magnétique présentant une direction d'anisotropie magnétique colinéaire avec une déviation angulaire d'au maximum $\pm 5°$, préférablement d'au maximum $\pm 3°$, particulièrement préférablement d'au maximum $\pm 2°$, **caractérisé en ce que** le substrat est fabriqué par moyen d'un procédé selon l'une des revendications 20 ou 21.

**23.** Substrat, préférablement circulaire, présentant un diamètre maximum d'au moins 100 mm, de préférence d'au moins 150 mm, particulièrement de préférence d'au moins 200 mm ou même de 300 mm, muni d'au moins deux couches magnétiques superposées, les couches magnétiques présentant chacune une direction d'anisotropie magnétique colinéaire chacune présentant une déviation angulaire d'au maximum $\pm 5°$, préférablement d'au maximum $\pm 3°$, particulièrement préférablement d'au maximum $\pm 2°$, les anisotropies des couches ayant préférablement des directions différentes, **caractérisé en ce que** le substrat est fabriqué par moyen du procédé selon l'une des revendications 20 ou 21.

**24.** Utilisation de l'agencement selon l'une des revendications 1 à 17 pour générer un champ magnétique colinéaire dans un plan prédéfini, dans laquelle on règle le plan prédéfini au lieu du plan de positionnement.

**25.** Utilisation selon la revendication 23 pour des tâches de mesure.

FIG.1

FIG.2

FIG.3

FIG.4

FIG.5

I : Spulensatz 1
II : Spulensatz 2

FIG.6

FIG.7

FIG.8

FIG.9

FIG.10

**EP 1 297 542 B1**

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- DE OS19643841 A
- US 5630916 A
- DE OS4312444 A
- EP 0435838 A
- EP 0584768 A
- US 4600488 A

**In der Beschreibung aufgeführte Nicht-Patentliteratur**

- **HUBERT BRÜCKL.** Non-Volatile Memory. Magnetic Storage Industry Sourcebook, 1999
- **OCKER, W. MAASS et al.** Spin Valves for High Density. Magnetic Storage